# EUROPEAN PATENT APPLICATION

(11) **EP 1 868 024 A1**
(43) Date of publication of application: **19.12.2007**
(21) Application number: 07100407.1
(22) Date of filing: 11.01.2007
(51) Int. Cl.: G02B 26/08, B81C 1/00

(54) **Micro-electro mechanical system device and method of forming comb electrodes of the same**

(30) Priority: 13.06.2006 KR 20060053142
(71) Applicant: Samsung Electronics Co., Ltd., Suwon-si, Gyeonggi-Do (KR)
(72) Inventor: Chung, Seok-whan, Gyeonggi-do (KR); Kang, Seok-jin, Gyeonggi-do (KR); Choi, Hyung, Gyeonggi-do (KR); Jeong, Hyun-ku, Gyeonggi-do (KR)
(74) Representative: Greene, Simon Kenneth

(57) **Abstract**

Provided are a micro-electro mechanical system (MEMS) device and a method of forming comb electrodes of the MEMS device. The method includes forming a plurality of parallel trenches at regular intervals in one side of a first silicon substrate so as to define alternating first and second regions at different heights on the one side of the first silicon substrate, oxidizing the first silicon substrate in order to form an oxide layer in the first and second regions having different heights, forming a polysilicon layer on the oxide layer to at least fill up the trenches so as to level the oxide layer having different heights, bonding a second silicon substrate directly to a top surface of the polysilicon layer, selectively etching the second silicon substrate and the polysilicon layer using a first mask so as to form upper comb electrodes vertically aligned with the first regions, selectively etching the first silicon substrate using a second mask so as to form lower comb electrodes vertically aligned with the second regions, and removing the oxide layer interposed between the upper comb electrodes and the lower comb electrodes.

## Description

### BACKGROUND OF THE INVENTION

The present invention relates to a micro-electro mechanical system (MEMS) device and a method of forming comb electrodes of the MEMS device, and more particularly, to a MEMS device having an improved comb electrode structure exhibiting linear input-output characteristics, and a method of forming comb electrodes of the MEMS device.

In various technical fields related to display devices, laser printers, precise measuring instruments, precise machining devices, etc., much research is being carried out to develop a small-sized MEMS device that is manufactured using micro-machining technologies. For example, in a display device, a MEMS device is used as an optical scanner for reflecting or deflecting a scanning light beam onto a screen.

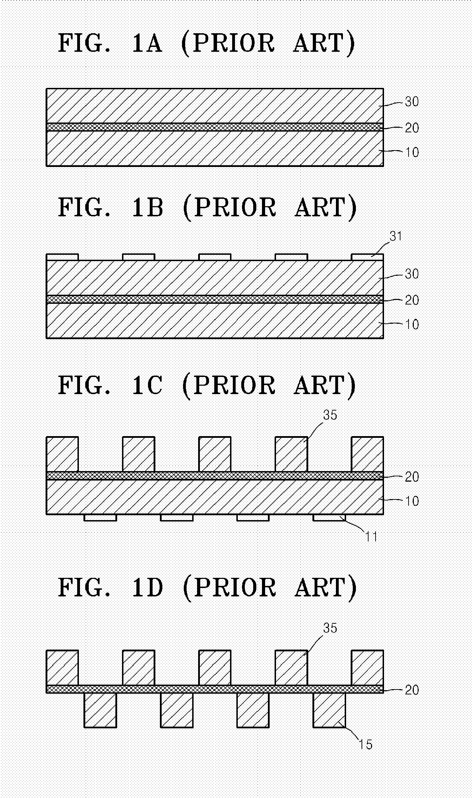

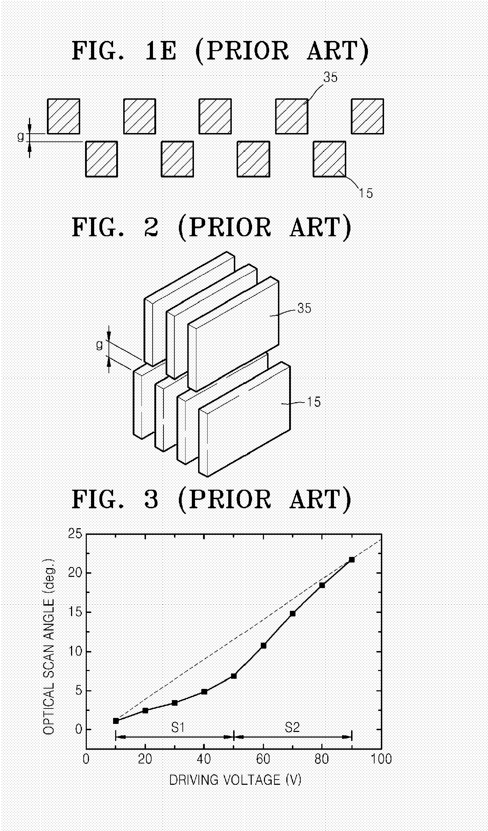

A MEMS device used as an optical scanner of a display device has a driving structure configured with interlocking comb electrodes. FIGS. 1A through 1 E are views for explaining a conventional method of forming comb electrodes. Referring to FIG. 1A, a silicon-on-insulator (SOI) substrate is prepared. The SOI substrate includes a first silicon substrate 30 and a second silicon substrate 10 that are bonded to either side of an oxide layer 20. Referring to FIGS. 1B and 1C, the first silicon substrate 30 is selectively etched using an etch mask 31 having a predetermined pattern so as to form a plurality of driving comb electrodes 35. Referring to FIG. 1C and 1D, an etch mask 11 is formed on the second silicon substrate 10 by using the driving comb electrodes 35 to align the etch mask 11, and then the second silicon substrate 10 is selectively etched using the etch mask 11 so as to form a plurality of fixed comb electrodes 15. Referring to FIG. 1 E, the oxide layer 20 formed between the driving comb electrodes 35 and the fixed comb electrodes 15 is removed, thereby completing forming of the driving and fixed comb electrodes 35 and 15. In the comb electrode structure formed by the conventional method, the driving comb electrodes 35 and the fixed comb electrodes 15 are spaced apart from each other in a vertical direction by a gap (g) equal to or larger than the thickness of the oxide layer 20. If the first and second silicon substrates 30 and 10 are in an etching environment for a long time, notches can be formed on edges of the comb electrodes 15 and 35. These notches increase the gap between the comb electrodes 15 and 35.

FIG. 2 shows a comb electrode structure formed by the method illustrated in FIGS. 1A through 1E. When a driving voltage is supplied between the neighboring comb electrodes 15 and 35, the lower fixed comb electrodes 15 electrostatically attract the driving comb electrodes 35, and thus a stage (not shown) is rotated. Here, the driving voltage supplied to the comb electrodes 15 and 35 is not linearly related to the rotation angle of the stage due to the vertical gap (g) between the comb electrodes 15 and 35.

FIG. 3 is a graph showing a relationship between an optical scan angle (output) and a driving voltage (input) in a conventional MEMS device used as an optical scanner. Referring to FIG. 3, in a first interval S1 (low-voltage interval), a linear relationship is substantially maintained between the optical scan angle and the driving voltage (the curve has an approximately constant slope). However, at a driving voltage of about 50 V, the slope of the curve changes suddenly. Then, in a second interval S2, which is higher than 50 V, the relationship is linearly maintained at differently sloped curve. Here, the point where the slope of the curve suddenly changes corresponds to a boundary point between the first interval S1 and the second interval S2. At the boundary point, the driving comb electrodes 35 are attracted by the fixed comb electrodes 15 and thus start to engage with the fixed comb electrodes 15. The first interval S1 corresponds to an interval where a low driving voltage is supplied between the driving comb electrodes 35 and the fixed comb electrodes 15 but the comb electrodes 35 and 15 are not yet engaged with each other. The second interval S2 corresponds to an interval where the comb electrodes 15 and 35 are engaged with each other owing to a high driving voltage supplied thereto. An ideal linear relationship between the optical scan angle and the driving voltage is indicated by the dashed line in FIG. 3. In the conventional non-linear comb electrode structure, a higher driving voltage is required to obtain the same optical scan angle as the ideal linear line.

When an image is displayed on a screen using a conventional MEMS device as an optical scanner, due to the non-linear relationship between the optical scan angel and the driving voltage, wrinkles and distortions appear on the image.

### SUMMARY OF THE INVENTION

The present invention provides a micro-electro mechanical system (MEMS) device having an improved comb electrode arrangement so as to linearize a relationship between driving voltage (input) and stage rotation angle (output), and a method of forming comb electrodes of the MEMS device.

According to an aspect of the present invention, there is provided a method of forming comb electrodes of a MEMS device, the method comprising: forming a plurality of parallel trenches at regular intervals in one side of a first silicon substrate so as to define alternating first and second regions at different heights on the one side of the first silicon substrate; oxidizing the first silicon substrate in order to form an oxide layer in the first and second regions having different heights; forming a polysilicon layer on the oxide layer to at least fill up the trenches so as to level the oxide layer having different heights; bonding a second silicon substrate directly to a top surface of the polysilicon layer; selectively etching the second silicon substrate and the polysilicon layer using a first mask so as to form upper comb electrodes vertically aligned with the first regions; selectively etching the first silicon substrate using a second mask so as to form lower comb electrodes vertically aligned with the second regions; and removing the oxide layer interposed between the upper comb electrodes and the lower comb electrodes.

According to another aspect of the present invention, there is provided a MEMS device comprising: a stage operating in a vibration mode; a frame disposed around the stage to support the stage and allow rotation of the stage; a plurality of driving comb electrodes extending in parallel with each other from the stage toward the frame; and a plurality of fixed comb electrodes extending from the frame and engaging with the driving comb electrodes, wherein the driving comb electrodes and the fixed comb electrodes are disposed at different heights and overlap each other by a predetermined length in a vertical direction.

### BRIEF DESCRIPTION OF THE DRAWINGS

The above and other features and advantages of the present invention will become more apparent by describing in detail exemplary embodiments thereof with reference to the attached drawings in which:
FIGS. 1A through 1E are views for explaining a conventional method of forming comb electrodes;
FIG. 2 shows a comb electrode structure formed by the method illustrated in FIGS. 1A through 1 E;
FIG. 3 is a graph showing a relationship between an optical scan angle (output) and a driving voltage (input) in a conventional micro-electro mechanical system (MEMS) device having the comb electrode structure depicted in FIG. 2;
FIG. 4 is a perspective view illustrating a MEMS device according to an embodiment of the present invention;
FIG. 5 is a perspective view illustrating a comb electrode structure of the MEMS device depicted in FIG. 4 according to an embodiment of the present invention; and
FIGS. 6A through 6I are vertical cross-sectional views for illustrating a method of forming comb electrodes according to an embodiment of the present invention.

### DETAILED DESCRIPTION OF THE INVENTION

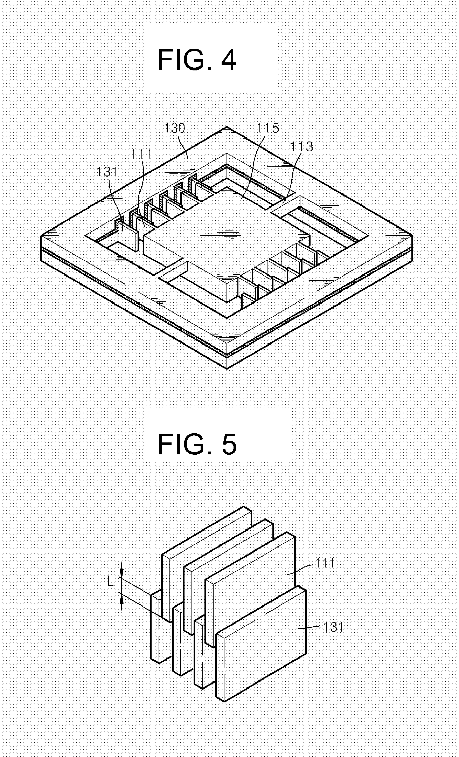

A micro-electro mechanical system (MEMS) device and a method of forming comb electrodes of the MEMS device will now be described more fully with reference to the accompanying drawings, in which exemplary embodiments of the invention are shown. FIG. 4 is a perspective view illustrating a MEMS device according to an embodiment of the present invention. Referring to FIG. 4, the MEMS device includes a stage 115 operating in vibration mode, torsion bars 113 about which the stage 115 rotates, and a frame 130 rotatably supporting the stage 115 by means of the torsion bars 113. A plurality of driving comb electrodes 111 and a plurality of fixed comb electrodes 131 are formed between opposing surfaces of the stage 115 and the frame 130. In detail, the driving comb electrodes 111 extend from both sides of the stage 115 toward the frame 130 in parallel with each other. The fixed comb electrodes 131 uniformly extend from inner surfaces of the frame 130 in parallel with each other and engage with the driving comb electrodes 111. The driving comb electrodes 111 and the fixed comb electrodes 131 are disposed adjacent to each other so as to be electrostatically attracted to each other. That is, when a driving voltage is supplied between the comb electrodes 111 and 131, the fixed comb electrodes 131 electrostatically attract the driving comb electrodes 111, and thus the stage 115 on which the driving comb electrodes 111 are formed rotates about the torsion bars 113 in a corresponding direction.

FIG. 5 is an enlarged perspective view of the comb electrode structure depicted in FIG. 4. Referring to FIG. 4, the driving comb electrodes 111 are vibrated between a first lower position and a second higher position. At the first position, the driving comb electrodes 111 engage with the lower fixed comb electrodes 131 to a maximum level, and at the second higher position, the driving comb electrodes 111 engage with the fixed comb electrodes 131 to a minimum level. That is, even when the driving comb electrodes 111 are placed in the first position farthest from the fixed comb electrodes 131, the driving comb electrodes 111 overlap the fixed comb electrodes 131 by a predetermined length (L) in a vertical direction. Thus, a gap is not permitted between the driving comb electrodes 111 and the fixed comb electrodes 131. When the driving comb electrodes 111 are grounded and a driving voltage (V) is supplied to the fixed comb electrodes 131, the driving comb electrodes 111 are pulled down to the fixed comb electrodes 131 by an electrostatic force, and thus the stage 115 is rotated. Here, since the driving comb electrodes 111 and the fixed comb electrodes 131 are engaged with each other by the length (L) in a vertical direction in a normal state (when no voltage is supplied), the driving voltage (V) (input) supplied to the fixed comb electrodes 131 is linearly related to the rotation angle (output) of the stage 115. Therefore, when the MEMS device is used as an optical scanner, the optical scan angle of the MEMS device can be linearly controlled, and thus the MEMS device can provide high-quality images without distortions.

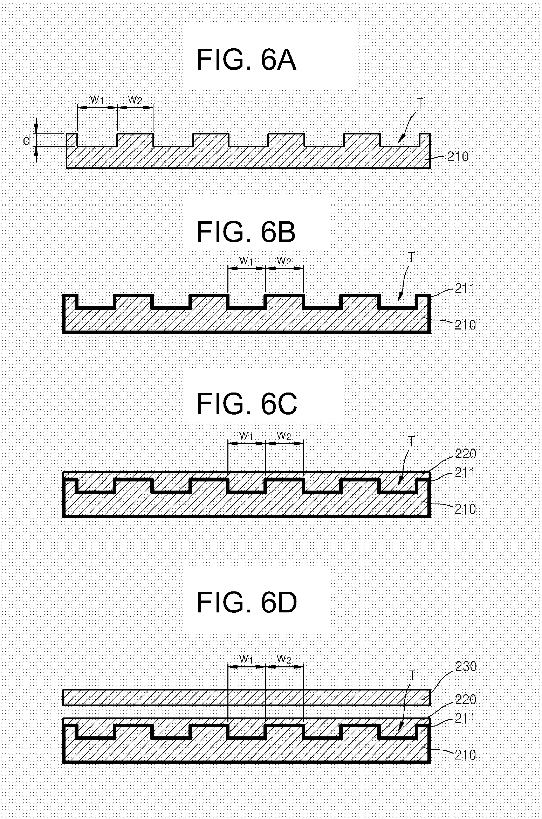

FIGS. 6A through 6I are vertical cross-sectional views for illustrating a method of forming comb electrodes according to an embodiment of the present invention. Referring to FIG. 6A, a plurality of trenches (T) are formed in a first silicon substrate 210 at uniform intervals. For example, in a photolithography process, a pattern mask (not shown) is formed on the first silicon substrate 210, and then the first silicon substrate 210 is selectively removed by reactive ion etching (RIE) to form the trenches (T). Upper comb electrodes 111 are to be formed in first regions W1 of the first silicon substrate 210 where the trenches (T) are formed, and lower comb electrodes 131 are to be formed in second regions W2 between the first regions W1. The trenches (T) have a depth (d), and this depth (d) is related to an overlapping length (L) between the upper comb electrodes 111 and the lower comb electrodes 131. The depth (d) of the trenches (T) is determined in consideration of manufacturing errors, so that the overlapping relationship between the upper and lower comb electrodes 111 and 131 is ensured and a vertical gap is not permitted between the upper and lower comb electrodes 111 and 131. Practically, the depth (d) of the trenches (T) may be small in comparison to the thickness of the first silicon substrate 210.

Referring to FIG. 6B, an oxide layer 211 is formed on the first silicon substrate 210 including the trenches (T) by using an oxidization process. The oxide layer 211 may be formed on the entire surface of the first silicon substrate 210 including the trenches (T) to a very small thickness by performing an oxidation process in a high-temperature oxidization environment. The oxide layer 211 formed on the top surface of the first silicon substrate 210 is patterned by the trenches (T), so that the oxide layer 211 has different heights in the first and second regions W1 and W2.

Referring to FIG. 6C, a polysilicon layer 220 is deposited on the first silicon substrate 210 in order to fill up the trenches (T). The polysilicon layer 220 may be formed by various methods, such as a low pressure chemical vapor deposition (LPCVD) method at a deposition temperature higher than 550°C, or a plasma enhanced chemical vapor deposition (PECVD) method using predetermined mixed gases at a temperature lower than 400°C. The polysilicon layer 220 may be formed to a sufficient thickness so as to fill up the trenches (T) completely. Furthermore, a silicon epitaxial layer (not shown) can be additionally formed on the polysilicon layer 220 depending on the depth (d) of the trenches (T).

Next, the polysilicon layer 220 is leveled by chemical mechanical polishing (CMP). In detail, protruding portions of the polysilicon layer 220 are removed by a polishing pad of a CMP apparatus so as to make the polysilicon layer 220 flat. Owing to this planarization (leveling), a second silicon substrate 230 (refer to FIG. 6D) can be firmly bonded to the first silicon substrate 210 (described below).

Referring to FIG. 6D, the second silicon substrate 230 is bonded to the top surface of the first silicon substrate 210. The first and second silicon substrates 210 and 230 can be bonded to each other by using a silicon direct bonding (SDB) process. In the SDB process, the first and second silicon substrates 210 and 230 are surface treated to make surfaces of the first and second silicon substrates 210 and 230 hydrophilic, and then the hydrophilic treated surfaces of the first and second silicon substrates 210 and 230 are are joined together in order to bond them by a hydrogen bond (primary bonding). After that, the first and second silicon substrates 210 and 230 are heat treated at a temperature of 800°C or higher so as to more firmly bond the first and second silicon substrates 210 and 230 together (secondary bonding).

Next, a top surface of the second silicon substrate 230 is polished by CMP to a predetermined thickness. In detail, the entire top surface of the second silicon substrate 230 is polished by a polishing pad of a CMP apparatus so as to make the second silicon substrate 230 thin. The thickness of the second silicon substrate 230 may be determined depending on the thickness of the upper comb electrodes 111 that are to be formed in the second silicon substrate 230.

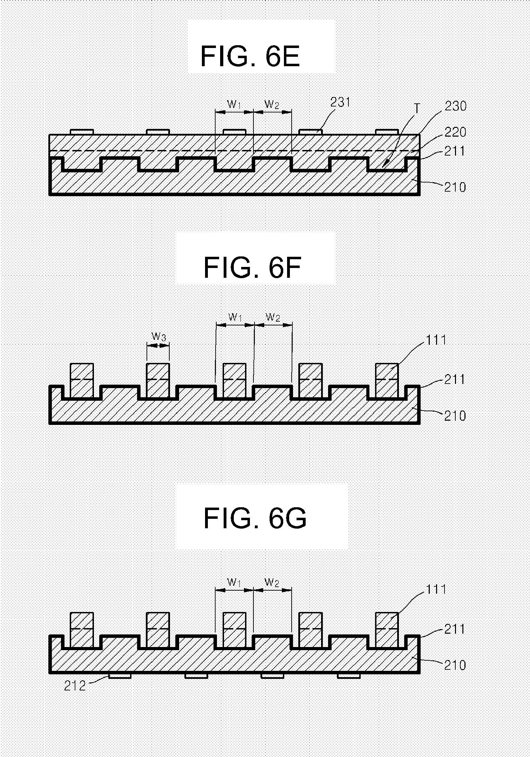

Next, the second silicon substrate 230 is selectively etched so as to form the upper electrodes 111. For example, referring to FIGS. 6E and 6F, a PR (photoresist) mask 231 is formed on the second silicon substrate 230 by using a predetermined pattern, and the second silicon substrate 230 and the polysilicon layer 220 are etched using the PR mask 231 as an etch barrier layer until the oxide layer 211 is exposed. The PR mask 231 is patterned in correspondence with the upper comb electrodes 111. Since the upper comb electrodes 111 should be formed in the first region W1 on the oxide layer 211, the PR mask 231 may be patterned based on the pattern of the oxide layer 211. Here, the first regions W1 may be wider than the upper comb electrodes 111 so as to prevent the upper comb electrodes 111 from departing from the first regions W1 due to alignment errors. Therefore, when the trenches (T) are formed in the first silicon substrate 210, the first regions W1 may be formed to be wider than the width W3 of the upper comb electrodes 111.

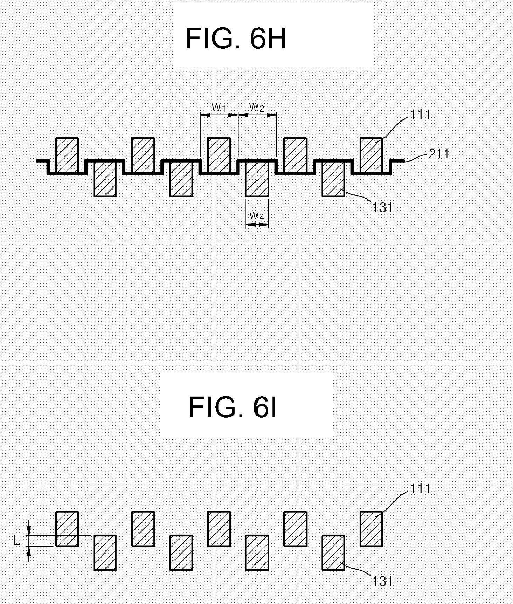

Next, the first silicon substrate 210 is selectively etched so as to form the lower electrodes 131. For example, referring to FIGS. 6G and 6H, the first silicon substrate 210 is etched using a PR mask 212 having a predetermined pattern as an etch barrier layer until the oxide layer 211 is exposed. The PR mask 212 is patterned in correspondence with the lower comb electrodes 131. Since the lower comb electrodes 131 should be formed between the upper comb electrodes 111, the PR mask 212 may be aligned based on the upper comb electrodes 111 that are already formed in the previous process. Since the lower comb electrodes 131 should be formed within the second regions W2 on the oxide layer 211, the second regions W2 can be wider than the lower comb electrodes 131 so as to provide predetermined process margin. Therefore, when the trenches (T) are formed in the first silicon substrate 210, the second regions W2 may be formed to be wider than the width W4 of the lower comb electrodes 111.

Then, the oxide layer 211 formed between the upper comb electrodes 111 and the lower comb electrodes 131 is removed by etching. For example, an etchant that reacts only with the oxide layer 211 may be applied to the whole structure so as to completely remove only the oxide layer 211. After the oxide layer 211 is removed, a comb electrode structure is completely obtained as shown in FIG. 71. In the completed comb electrode structure, the upper and lower comb electrodes 111 and 131 are arranged so as to overlap each other by a predetermined length (L) in a vertical direction. The upper comb electrodes 111 may be used as driving comb electrodes attached to a stage and rotating with the stage, and the lower comb electrodes 131 may be used as fixed comb electrodes.

In the MEMS device and the method of forming the comb electrodes of the MEMS device according to the present invention, the driving comb electrodes and the fixed comb electrodes are arranged at different heights and overlap each other by a predetermined length, so that the MEMS device can exhibit an ideal linear relationship between the driving voltage (input) and the rotation angle of the stage (output). For example, when the MEMS device is used as an optical scanner of a display device, scan lines can be precisely controlled owing to the linear input-output relationship, thereby preventing image distortions and wrinkles. Thus, a high-quality image display can be provided.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A method of forming comb electrodes of a MEMS (micro-electro mechanical system) device, the method comprising:
forming a plurality of parallel trenches at regular intervals in one side of a first silicon substrate so as to define alternating first and second regions at different heights on the one side of the first silicon substrate;
oxidizing the first silicon substrate in order to form an oxide layer in the first and second regions having different heights;
forming a polysilicon layer on the oxide layer to at least fill up the trenches so as to level the oxide layer having different heights;
bonding a second silicon substrate directly to a top surface of the polysilicon layer;
selectively etching the second silicon substrate and the polysilicon layer using a first mask so as to form upper comb electrodes vertically aligned with the first regions;
selectively etching the first silicon substrate using a second mask so as to form lower comb electrodes vertically aligned with the second regions; and
removing the oxide layer interposed between the upper comb electrodes and the lower comb electrodes.

2. The method of claim 1, further comprising planarizing the polysilicon layer by CMP (chemical mechanical polishing) after the forming of the polysilicon layer.

3. The method of claim 1 or 2, further comprising growing an additional epitaxial layer on the polysilicon layer depending on the depth of the trenches after the forming of the polysilicon layer.

4. The method of claim 1, 2 or 3, further comprising polishing a top surface of the second silicon substrate by CMP so as to thin the second silicon substrate to a desired thickness after the bonding of the second silicon substrate.

5. The method of any preceding claim, wherein the bonding of the second silicon substrate is performed by SDB (silicon direct bonding).

6. The method of any preceding claim, wherein the upper comb electrodes formed in the first regions overlap with the lower comb electrodes formed in the second regions, and the overlapping length between the upper comb electrodes and the lower comb electrodes corresponds to the height difference between the first and second regions.

7. The method of any preceding claim, wherein the first mask is vertically aligned with the oxide layer formed in the first regions.

8. The method of any preceding claim, wherein the second mask is vertically aligned with the second regions by using the upper comb electrodes that are already formed.

9. The method of any preceding claim, wherein the first regions are wider than the upper comb electrodes.

10. The method of any preceding claim, wherein the second regions are wider than the lower comb electrodes.

11. A MEMS device comprising:
a stage operating in a vibration mode;
a frame disposed around the stage to support the stage and allow rotation of the stage;
a plurality of driving comb electrodes extending in parallel with each other from the stage toward the frame; and
a plurality of fixed comb electrodes extending from the frame and engaging with the driving comb electrodes,
wherein the driving comb electrodes and the fixed comb electrodes are disposed at different heights and overlap each other by a predetermined length in a vertical direction.

12. The MEMS device of claim 11, wherein the driving comb electrodes and the fixed comb electrodes overlap each other in the vertical direction so as to prevent a vertical gap between the driving comb electrodes and the fixed comb electrodes.
